# EUROPEAN PATENT SPECIFICATION

(11) **EP 3 992 642 B1**
(45) Date of publication and mention of the grant of the patent: **07.06.2023**
(21) Application number: 20771962.6
(22) Date of filing: 01.09.2020
(51) Int. Cl.: G01R 15/18, G01R 31/52, G01R 31/58

(54) **SYSTEM FOR MONITORING CIRCULATING CURRENT OF HIGH-VOLTAGE CABLE METAL SHEATH**
SYSTEM ZUR ÜBERWACHUNG DES UMLAUFSTROMS DES MENTALLMANTELS EINES HOCHSPANNUNGSKABELS
SYSTÈME DE SURVEILLANCE DE COURANT DE CIRCULATION D'UNE GAINE MÉTALLIQUE DE CÂBLE HAUTE TENSION

(43) Date of publication of application: 04.05.2022
(73) Proprietor: Hangzhou Juqi Information Technology Co., Ltd., Hangzhou, Zhejiang 311400 (CN)
(72) Inventor: NI, Xiaolu, Hangzhou, Zejiang 311400 (CN); ZHOU, Mingquan, Hangzhou, Zejiang 311400 (CN); MENG, Qingming, Hangzhou, Zejiang 311400 (CN); GUO, Nengjun, Hangzhou, Zejiang 311400 (CN); ZHOU, Jie, Hangzhou, Zejiang 311400 (CN); DONG, Qi, Hangzhou, Zejiang 311400 (CN); QIU, Mingsong, Hangzhou, Zejiang 311400 (CN)
(74) Representative: Zaboliene, Reda
(86) International application number: PCT/CN2020/112756
(87) International publication number: WO 2022/047601

(56) References cited:
- WO-A1-2019/233483
- CN-A- 103 972 806
- CN-A- 106 950 463
- CN-A- 108 100 960
- CN-A- 108 508 253
- CN-A- 110 412 330
- CN-A- 110 412 330
- CN-A- 110 441 576
- CN-U- 206 930 736
- CN-Y- 201 247 303
- FR-A1- 2 710 156
- JP-A- 2000 009 786
- US-A- 5 677 678
- US-A1- 2011 192 315
- US-A1- 2014 203 799

## Description

### BACKGROUND OF THE INVENTION

### 1. Technical Field

The invention relates to the technical field of cable monitoring, in particular to a monitoring system for circular current of a high-voltage cable metal sheath.

### 2. Description of Related Art

In recent years, with the vigorous construction of cities, more and more cables are laid in cities, and problems about cable usage are caused accordingly. When grounded, both terminals of a high-voltage cable metal sheath will form a path together with the ground, thus generating circular current. In case of improper grounding of the sheath, the circular current will reach hundreds of amperes and lead to a great loss of the metal sheath, thus affecting the carrying capacity of the cable and accelerating insulation aging of the cable. Moreover, a ground wire may be overheated and catches a fire, thus causing cable accidents. In view of this, it is necessary to carry out relevant detection and analytical calculation on the circular current of the cable metal sheath. Existing detection operations are inconvenient, the detection efficiency is low, and thus, a monitoring system for circular current of a high-voltage cable metal sheath is needed.

CN 110 412 330 A discloses a monitoring system for a ground loop current in a high voltage cable sheath comprising a vehicle and an inductive current sensor. US 2014/203799 A1 discloses a line inspection robot suspended from the cable sheath of an overhead line, the robot comprising a plurality of sensor systems inside a housing and a pair of trucks attached to the housing and the cable sheath for allowing the robot to move along the cable sheath. The robot further comprises a current transformer for power harvesting. WO 2019/233483 A1 discloses a maintenance robot for substations comprising a vehicle and a robot arm with maintenance tools attached to the robot arm and a leakage current sensor for monitoring the insulated arm.

### BRIEF SUMMARY OF THE INVENTION

The objective of the invention is to provide a monitoring system for circular current of a high-voltage cable metal sheath to solve the problems of the prior art.

To fulfill the above objective, the invention adopts the following technical solution:

A monitoring system for circular current of a high-voltage cable metal sheath comprises a mobile vehicle, wherein a lifting assembly is mounted on one side of the mobile vehicle, a pushing assembly is horizontally mounted at an end, stretching out of the top of the mobile vehicle, of the lifting assembly, a detection assembly is connected to an end, away from the lifting assembly, of the pushing assembly and comprises a detection mechanism fixedly connected with an output end of the pushing assembly, and a protection mechanism is connected to one side of the detection mechanism;

The detection mechanism comprises a rotary shaft which is movably connected with the output end of the pushing assembly, a fixed connecting plate fixedly connected with the output end of the pushing assembly is movably connected to an outer circle of the rotary shaft, a movable connecting plate fixedly connected with the rotary shaft is mounted on a side, away from the pushing assembly, of the fixed connecting plate, housings which are each of an arc structure and each have two ends formed with openings are fixedly connected to identical sides of the movable connecting plate and the fixed connecting plate, the two housings are opposite to each other, magnetic cores which are coaxial with the housings and are each of an arc structure are mounted in the two housings, coils which are each of a circular structure are wound on outer circles of the magnetic cores, outer circles of the coils are clad with clad layers which are fixedly connected with inner walls of the housings, contact blocks are fixedly connected to inner walls of the openings in the two ends of each of the two housings, and a wiring tube is fixedly connected to the top of the housing located on the fixed connecting plat;

The protection mechanism comprises shells which are fixedly connected with outer walls of the housings, each have two ends formed with openings, and are each of a circular structure, the two shells are coaxial with the adjacent housings, protection units are mounted at the openings of the two shells, a connecting unit which is of a circular structure is fixedly connected to the tops of sides, close to each other, of the two protection units in each shell, and pushing units for opening and closing the protection units are mounted at the openings in sides, close to the rotary shaft, of the shells.

Preferably, each protection unit comprises protection plates located at the openings in the two ends of the corresponding shell, wherein first guide tubes are fixedly connected to the tops of sides, close to each other, of the two protection plates and are located over ends, away from the corresponding housing, of the protection plates, movable rods are movably connected into the first guide tubes, springs which are fixedly connected with the tops of the protection plates are fixedly connected to ends, stretching into the first guide tubes, of the movable rods, screw rods which are disposed in a lengthwise direction of the protection plates are connected to ends, stretching out of the tops of the first guide tubes, of the movable rods in a threaded manner and are movably connected with an inner wall of the corresponding shell, gears are fixedly connected to outer circles of the screw rods, abutting plates which are disposed in the lengthwise direction of the protection plates are fixedly connected to the tops of sides, away from each other, of the two protection plates, and the tops of sides, close to the corresponding housing, of the abutting plates abut against pushing blocks which are fixedly connected with the inner wall of the corresponding shell.

Preferably, each pushing unit comprises a second guide tube which is fixedly connected with an inner wall of an outer circle of the corresponding shell and is of an arc structure, a pushing plate which is of an arc structure is slidably connected into the second guide tube, an end, stretching out of the second guide tube, of the pushing plate is fixedly connected with the inner wall of the outer circle of the adjacent shell, and a rack which is disposed in a lengthwise direction of the pushing plate and is of an arc structure is fixedly connected to a concave face of the pushing plate, and is engaged with a gear.

Preferably, ach connecting unit comprises a connecting rod which is slidably connected with an inner wall of an inner circle of the corresponding shell and is of an arc structure, and the connecting rod slides in an axis direction of the corresponding shell and has two ends slidably sleeved with third guide tubes which are fixedly connected with the tops of the adjacent protection plates.

Preferably, a storage cavity which is of a hollow structure is formed in the mobile vehicle, and wheels for moving the mobile vehicle are mounted at the bottom of the mobile vehicle.

Preferably, the lifting assembly comprises a first lifting tube movably connected with the mobile vehicle and is able to slide vertically with respect to the mobile vehicle, a second lifting tube which is able to move in a lengthwise direction of the first lifting tube is slidably connected to an end, stretching out of the top of the mobile vehicle, of the first lifting tube, an end, stretching out of the first lifting tube, of the second lifting tube is fixedly connected with the bottom of the pushing assembly, a first rotary tube is connected to an inner circle of the second lifting tube in a threaded manner, an adapter rod which slides in a lengthwise direction of the first rotary tube is slidably connected to an inner circle of the bottom of the first rotary tube, a driving rod is fixedly connected to the bottom of the adapter rod, a second rotary tube which is movably connected with an inner circle of the first lifting tube in a threaded manner is slidably connected to an outer circle of the driving rod, and a driving mechanism is fixedly connected to an outer circle of an end, stretching out of the first lifting tube, of the second rotary tube.

Preferably, the driving mechanism comprises a gear ring which is fixedly connected to an outer circle of the bottom of the second rotary tube, one side of the gear ring is engaged with a second gear, a first rotary shaft is fixedly connected to an inner circle of the second gear, a first motor which is fixedly connected with an inner wall of the bottom of the storage cavity of the mobile vehicle is mounted at the bottom of the first rotary shaft, a retainer plate which is movably connected with the second rotary tube is mounted on one side of the gear ring and is fixedly connected with an inner wall of the storage cavity, and a second motor which is fixedly connected with the inner wall of the bottom of the storage cavity is fixedly connected to an end, stretching out of the bottom of the second rotary tube, of the driving rod.

Through the arrangement of the mobile vehicle, the lifting assembly, the pushing assembly, the detection assembly, the detection mechanism, the protection mechanism, the connecting units, the pushing units, the protection units, the second rotary tubes, the first lifting tubes, the second lifting tubes, the first rotary tubes, the adapter rods, the driving rods, the driving mechanism, the housings, the magnetic cores, the coils, the clad layers, the wiring tubes, the fixed connecting plate, the rotary shaft, the movable connecting plate, the shells, the third guide tubes, the connecting rods, the second guide tubes, the pushing plates, the racks, the protection plates, the first guide tubes, the movable rods, the screw rods, the racks, the abutting plates and the pushing blocks, the design can fulfill automatic and rapid detection of circular current of a cable metal sheath and can automatically jump over a bracket for mounting a cable during detection; debris such as dust is effectively prevented from entering the detection mechanism in operation, and the protection function and quality are improved; and the circular current of a ground cable metal sheath can be easily detected, the defection efficiency is improved, and labor intensity is relieved.

### BRIEF DESCRIPTION OF THE SEVERAL VIEWS OF THE DRAWINGS

FIG. 1 is a structural diagram of a monitoring system for circular current of a high-voltage cable metal sheath provided by the invention;
FIG. 2 is a structural diagram of a detection mechanism of the monitoring system for circular current of a high-voltage cable metal sheath provided by the invention;
FIG. 3 is a structural diagram of a protection mechanism of the monitoring system for circular current of a high-voltage cable metal sheath provided by the invention;
FIG. 4 is a partial enlarged view of the monitoring system for circular current of a high-voltage cable metal sheath provided by the invention;
FIG. 5 is a distribution diagram of a detection mechanism and a protection mechanism of the monitoring system for circular current of a high-voltage cable metal sheath provided by the invention;
FIG. 6 is a structural diagram of a protection unit of the monitoring system for circular current of a high-voltage cable metal sheath provided by the invention;
FIG. 7 is a structural diagram of a lifting assembly of the monitoring system for circular current of a high-voltage cable metal sheath provided by the invention;

In the Figures: 1, mobile vehicle; 2, lifting assembly; 3, pushing assembly; 4, detection assembly; 5, detection mechanism; 6, protection mechanism; 7, connecting unit; 8, pushing unit; 9, protection unit; 101, second rotary tube; 102, first lifting tube; 103, second lifting tube; 104, first rotary tube; 105, adapter rod; 106, driving rod; 107, driving mechanism; 501, housing; 502, magnetic core; 503, coil; 504, clad layer; 506, wiring tube; 507, fixed connecting plate; 508, rotary shaft; 509, movable connecting plate; 601, shell; 701, third guide tube; 702, connecting rod; 801, second guide tube; 802, pushing plate; 803, rack; 901, protection plate; 902, first guide tube; 903, movable rod; 904, screw rod; 905, rack; 906, abutting plate; 907, pushing block.

### DETAILED DESCRIPTION OF THE INVENTION

Technical solutions of the embodiments of the invention are clearly and completely described below in conjunction with the accompanying drawings of the embodiments of the invention. Clearly, the embodiments described hereafter are merely illustrative ones, and are not all possible ones of the invention.

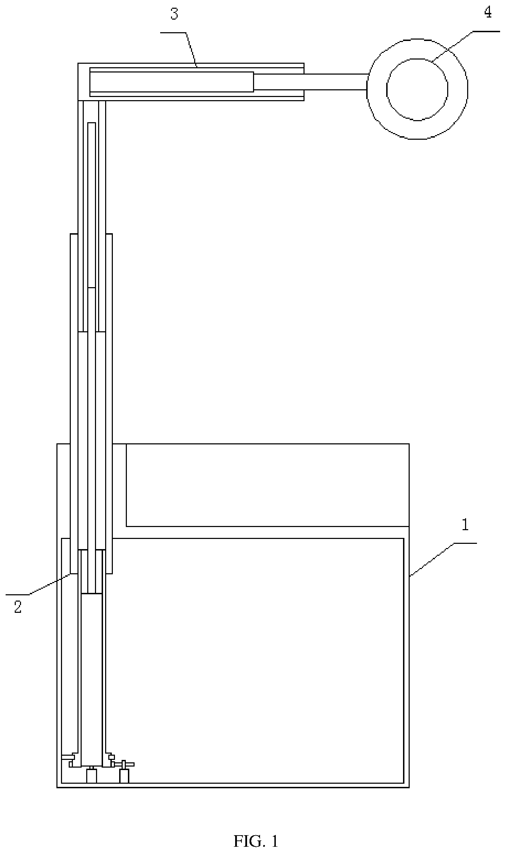

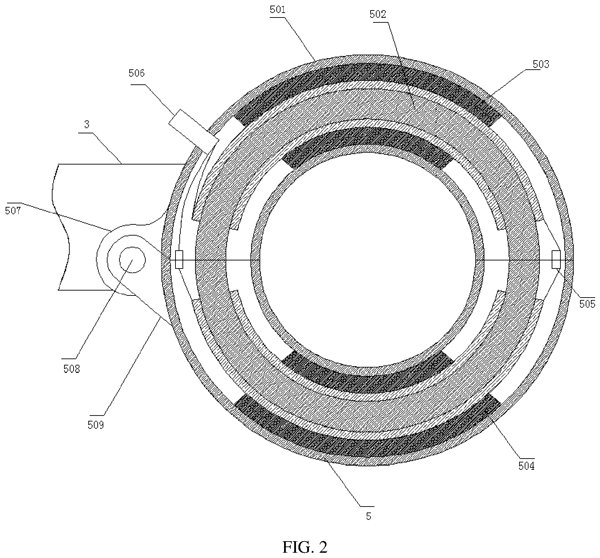

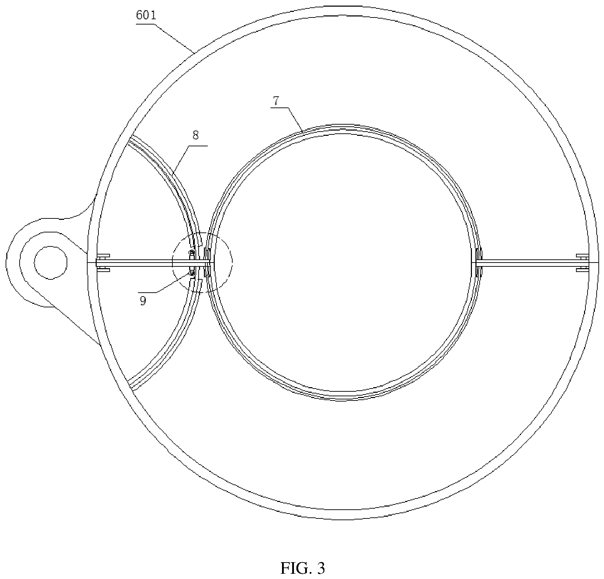

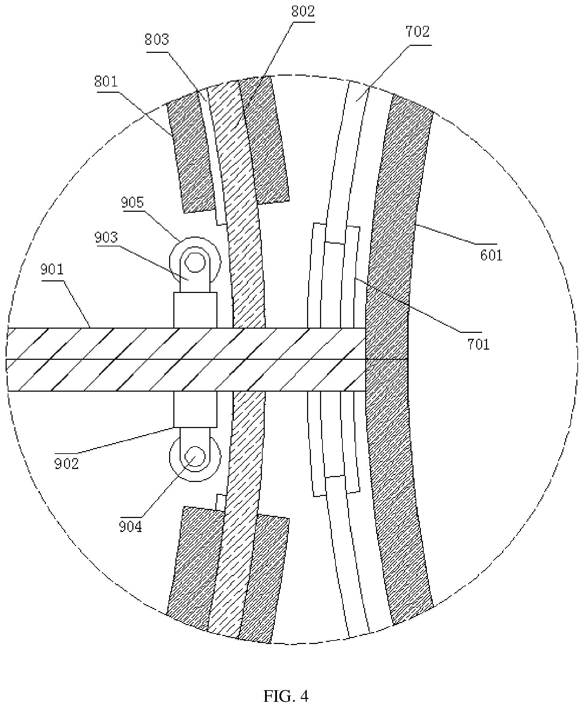

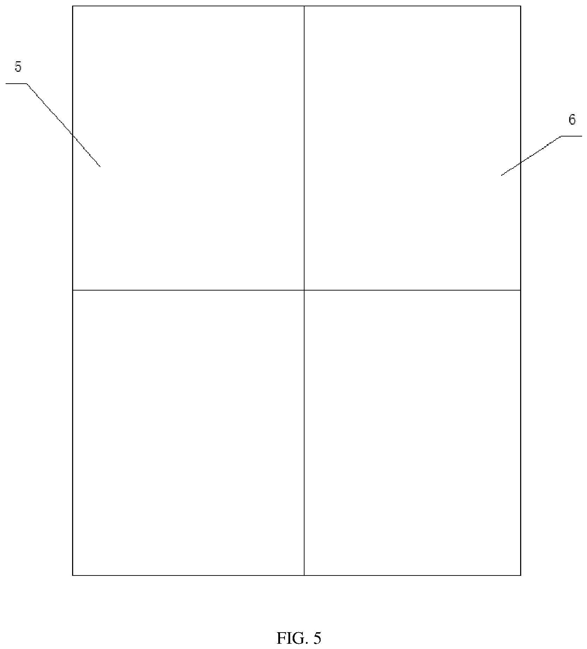

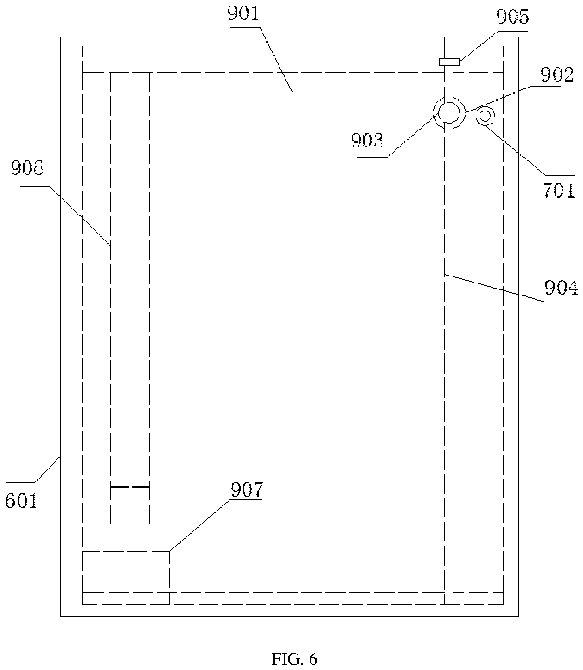

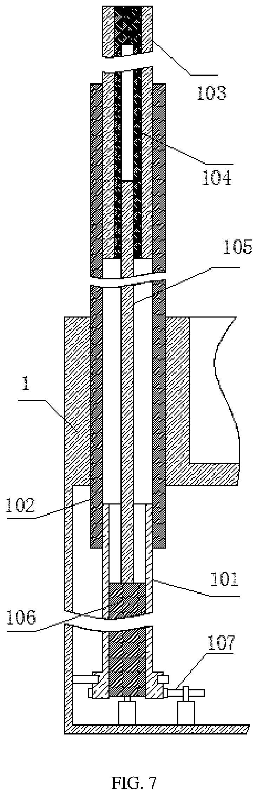

Referring to FIG. 1-FIG. 7, a monitoring system for circular current of a high-voltage cable metal sheath comprises a mobile vehicle 1, wherein a lifting assembly 2 is mounted on one side of the mobile vehicle 1, a pushing assembly 3 is horizontally mounted at an end, stretching out of the top of the mobile vehicle 1, of the lifting assembly 2, an end, away from the lifting assembly 2, of the pushing assembly 3 is connected with a detection assembly 4, the detection assembly 4 comprises a detection mechanism 5 fixedly connected with an output end of the pushing assembly 3, and a protection mechanism 6 is connected to one side of the detection mechanism 5.

Furthermore, the detection mechanism 5 comprises a rotary shaft 508 which is movably connected with the output end of the pushing assembly 3, a fixed connecting plate 507 fixedly connected with the output end of the pushing assembly 3 is movably connected to an outer circle of the rotary shaft 508, a movable connecting plate 509 which is fixedly connected with the rotary shaft 508 is mounted on a side, away from the pushing assembly 3, of the fixed connecting plate 507, housings 501 which are each of an arc structure and each have two ends formed with openings are fixedly connected to identical sides of the movable connecting plate 509 and the fixed connecting plate 507, the two housings 501 are opposite to each other, magnetic cores 502 which are coaxial with the housings 501 and are each of an arc structure are mounted in the two housings 501, coils 503 which are each of a circular structure are wound on outer circles of the magnetic cores 502, outer circles of the coils 503 are clad with clad layers 504 which are fixedly connected to inner walls of the housings 501, contact blocks 505 are fixedly connected to inner walls of the openings in the two ends of each of the two housings 501, and a wiring tube 506 is fixedly connected to the top of the housing 501 located on the fixed connecting plate 507;

Specifically, the protection mechanism 6 comprises shells 601 which are fixedly connected with outer walls of the housings 501, each have two ends formed with openings and are each of a circular structure, the two shells 601 are coaxial with the adjacent housings 501, protection units 9 are mounted at the openings of the two shells 601, a connecting unit 7 of a circular structure is fixedly connected to tops of sides, close to each other, of the two protection units 9 located in each shell 601, and pushing units 8 for opening and closing the protection units 9 are mounted at the openings in sides, close to the rotary shaft 508, of the shells 601.

Particularly, each protection unit 9 comprises protection plates 901 located at the openings in the two ends of the corresponding shell 601, wherein first guide tubes 902 are fixedly connected to tops of sides, close to each other, of the two protection plates 901 and are located above ends, away from the corresponding housing 501, of the protection plates 901, movable rods 903 are movably connected into the first guide tubes 902, springs which are fixedly connected with the tops of the protection plates 901 are connected to ends, stretching into the first guide tubes 902, of the movable rods 903, screw rods 904 which are disposed in a lengthwise direction of the protection plates 901 are connected into ends, stretching out of the tops of the first guide tubes 902, of the movable rods 903 in a threaded manner and are movably connected to an inner wall of the corresponding shell 601, gears 905 are fixedly connected to outer circles of the screw rods 904, abutting plates 906 which are disposed in the lengthwise direction of the protection plates 901 are fixedly connected to the tops of sides, away from each other, of the two protection plates 901, and the tops of sides, close to the corresponding housing 501, of the abutting plates 906 abut against pushing blocks 907 fixedly connected with the inner wall of the corresponding shell 601.

In addition, each pushing unit 8 comprises a second guide tube 801 which is fixedly connected with an inner wall of an outer circle of the corresponding shell 601 and is of an arc structure, a pushing plate 802 which is of an arc structure is slidably connected into the second guide tube 801, an end, stretching out of the second guide tube 801, of the pushing plate 802 is fixedly connected with the inner wall of the outer circle of the adjacent shell 601, and a rack 803 which is disposed in a lengthwise direction of the pushing plate 802 and is of an arc structure is fixedly connected to a concave face of the pushing plate 802, and is engaged with the corresponding gear 905.

Moreover, each connecting unit 7 comprises a connecting rod 702 which is slidably connected with an inner wall of an inner circle of the corresponding shell 601 and is of an arc structure, and the connecting rod 702 slides in an axis direction of the corresponding shell 601 and has two ends slidably sleeved with third guide tubes 701 which are fixedly connected with the tops of the adjacent protection plates 901.

It should be noted that a storage cavity which is of a hollow structure is formed in the mobile vehicle 1, and wheels for moving the mobile vehicle 1 are mounted at the bottom of the mobile vehicle 1.

Furthermore, the lifting assembly 2 comprises a first lifting tube 102 movably connected with the mobile vehicle 1 and is able to slide vertically with respect to the mobile vehicle 1, a second lifting tube 103 which is able to move in a lengthwise direction of the first lifting tube 102 is slidably connected to an end, stretching out of the top of the mobile vehicle 1, of the first lifting tube 102, an end, stretching out of the first lifting tube 102, of the second lifting tube 103 is fixedly connected with the bottom of the pushing assembly 3, a first rotary tube 104 is connected to an inner circle of the second lifting tube 103 in a threaded manner, an adapter rod which slides in a lengthwise direction of the first rotary tube 104 is slidably connected to an inner circle of the bottom of the first rotary tube 104, a driving rod 106 is fixedly connected to the bottom of the adapter rod 105, a second rotary tube 101 which is movably connected with an inner circle of the first lifting tube 102 in a threaded manner is slidably connected to an outer circle of the driving rod 106, and a driving mechanism 107 is fixedly connected to an outer circle of an end, stretching out of the first lifting tube 102, of the second rotary tube 101.

### Embodiment 1:

The driving mechanism 107 comprises a gear ring which is fixedly connected with an outer circle of the bottom of the second rotary tube 101, one side of the gear ring is engaged with a second gear, a first rotary shaft is fixedly connected to an inner circle of the second gear, a first motor which is fixedly connected with an inner wall of the bottom of the storage cavity of the mobile vehicle 1 is mounted at the bottom of the first rotary shaft, a retainer plate which is movably connected with the second rotary tube 101 is mounted on one side of the gear ring and is fixedly connected with an inner wall of the storage cavity, and a second motor which is fixedly connected with the inner wall of the bottom of the storage cavity is fixedly connected to an end, stretching out of the bottom of the second rotary tube 101, of the driving rod 106.

### Embodiment 2:

A third motor is mounted on a side, stretching out of the output end of the pushing assembly 3, of the rotary shaft 508, a controller and a storage battery are mounted in the storage cavity, a display, a power interface, a data interface and a rocker switch are mounted on one side of the mobile vehicle 1, a piston motor is used as the pushing assembly 3, an ARM single-chip microcomputer is used as the controller, and the controller is electrically connected to the first motor, the second motor, the piston motor, the third motor, the storage battery, the display, the power interface, the data interface and the rocker switch.

Operating principle: first of all, the system is placed on the ground on one side of a to-be-detected cable; then, the controller controls the first motor according to the position and height of the cable with respect to the ground; when the first motor is started, the first rotary shaft is driven to rotate to enable the second gear and the gear ring to rotate; after that, the second rotary tube 101 rotates to drive the first lifting tube 102 to vertically move upwards; at this moment, the second motor is not started, so that the driving rod 106 will not rotate, and the rotary rod 105 and the first rotary tube 104 do not rotate either, and a locking effect is realized by threads between the first rotary tube 104 and the second lifting tube 103; when the first lifting tube 102 moves upwards, the pushing assembly 3 located at the top of the second lifting tube 102 is pushed upwards, the second lifting tube 103 at the bottom of the pushing assembly 3 is driven by the pushing assembly 3 to move upwards, and, the rotary rod 105 slides downwards along the inner circle of the first rotary tube 104;

To ensure that the pushing assembly 3 can rise steadily, a slideway which is communicated with the storage cavity in the mobile vehicle 1 is disposed at the top of the mobile vehicle and is slidably connected with the first lifting tube 102, guide strips which are arranged vertically are fixedly connected to the outer circle of the first lifting tube 102 and the outer circle of the second lifting tube 103, guide grooves allowing the guide strips to be slidably connected thereto are reserved in the inner circle of the slideway and the inner circle of the first lifting tube 102, and the cross-section of the rotary rod 105 and the cross-section of the inner circle of the first rotary tube 104 are each of a regular polygon structure, so that the rotary rod 105 and the first rotary tube 104 can rotate synchronously along with the driving rod 106;

When the pushing assembly 3 needs to be adjusted upwards after the first motor is started and drives the first lifting tube 102 to move upwards, the second motor is started to drive the driving rod 106 to rotate, and the first rotary tube 104 is driven by the rotary rod 104 to rotate and then drives the second lifting tube 103 to move upwards under the effect of threads, so that the pushing assembly 3 is lifted again;

When detection is carried out, the third motor located on the rotary shaft 508 is started to drive the movable connecting plate 509 fixedly connected with the rotary shaft 508 to deflect downwards, then the lower housing 501 rotates away from the upper housing 501 to open the detection mechanism 5, and the shells 601 connected with the housings 501 are driven to move away from each other when the two housings 501 of an arc structure move away from each other; meanwhile, when the detection system is started, the lower shell 601 moves relative to the upper shell 601, the pushing plate 802 of the pushing unit 8 located on the lower shell 601 is fixedly connected to the inner wall of the upper shell 601, and the pushing plate 802 of the pushing unit 8 on the upper shell 601 is fixedly connected with the inner wall of the lower shell 601; when the two shells 601 move away from each other, the pushing plate 802 of the pushing unit on the lower shell 601 moves downwards with respect to the upper shell 601, the pushing plate 802 of the pushing unit 8 on the lower shell 601 moves upwards, at this moment, the pushing plates 802 of the two pushing units 8 move with respect to the gears 905 to drive the gears 905 on the protection units 9 to rotate, then the gears 905 drive the screw rods 904 to rotate, the movable rods 903 move towards the housings 501 under the effect of the screw rods 904, the protection plates 901 are driven to move towards the housings 501, the protection plates 901 at the openings of each shell 601 are driven by the corresponding connecting unit 7 to move synchronously; when the protection plates 901 move, the pushing blocks 907 located on the shells 601 push the protection plates 901 out of the openings of the shells 601 until the protection plates 901 moved to the openings of the housings 501 to cover the openings of the housings 501, so that the openings of the housings 501 are sealed, debris such as dust is effectively prevented from entering the detection mechanism via the openings of the housings 501 in the detection process and will not adhere to two ends of the magnetic cores 502 and the contact blocks 505, poor contact between the magnetic cores 502 and the contact blocks 505 is effectively avoided, and the protection level and quality of the detection assembly 4 are improved;

After the detection mechanism 5 is started, the pushing assembly 3 pushes the detection assembly 4 to move towards the to-be-detected cable until the cable is located in the middle of the inner circles of the housings 501; after that, the motor on the rotary shaft 508 is started, the two housings 501 are made to move close to each other by performing the above steps reversely to enable the detection mechanism 5 to close to form a circular structure allowing the to-be-detected cable to be wrapped therein, the magnetic cores 502 in the upper and lower housings 501 abut against each other, the abutting blocks 505 abut against each other, one end of the coil 503 on the outer circle of the upper housing 502 is connected with one contact block 505 of the upper housing 502, the other end of the coil 503 on the outer circle of the upper housing 502 is connected with one wiring terminal of the wiring tube 506, the other wiring terminal of the wiring tube 506 is connected with a resistor and a capacitor in parallel, the other terminal of the resistor and the other terminal of the capacitor are fixedly connected with the other abutting block 505 of the upper housing 501, and the two ends of the coil 503 of the lower housing 501 are respectively connected with the abutting blocks 505 of the lower housing 501; and after the detection mechanism is closed, the coils 503 on the upper and lower magnetic cores 502 form a detection circuit in an on-state;

In the detection process, touch switches are inlaid in outer walls of the sides, away from each other, of the housings 501 and the shells 601; when the detection assembly 4 moves to a bracket for mounting the cable, the touch switches will be triggered, the third motor on the rotary shaft 508 will be started to start the detection mechanism 5 and then start the pushing assembly 3, the detection mechanism 5 moves away from the cable, then the mobile vehicle 1 advances to jump over the bracket of the cable, and then detection continues as mentioned above.

To sum up, the design can fulfill automatic and rapid detection of circular current of a cable metal sheath and can automatically jump over a bracket for mounting a cable during detection; debris such as dust is effectively prevented from entering the detection mechanism in operation, and the protection function and quality are improved; and the circular current of a ground cable metal sheath can be easily detected, the defection efficiency is improved, and labor intensity is relieved.

It should be understood that in the description of the invention, the terms such as "center", "lengthwise", "crosswise", "length", "width", "thickness", "upper", "lower", "front", "back", "left", "right", "vertical", "horizontal", "top", "bottom", "inner", "outer", "clockwise", "anticlockwise" are used to indicate directional or positional relations on the basis of the drawings merely for the purpose of facilitating and simplifying the description of the invention, do not indicate or imply that a device or element referred to must have a specific direction or must be constructed or operated in a specific direction, and thus should not be construed as limitations of the invention.

Moreover, the terms "first" and "second" are merely for the purpose of illustration, and do not indicate or imply relative importance and do not implicitly point out the number of technical features referred to. Therefore, when the term "first" or "second" is used to define a feature, it may clearly or implicitly indicates the inclusion of one or more such features. In the description of the invention, "multiple" refers to two or more, unless otherwise specifically defined.

The above embodiments are merely preferred specific embodiments of the invention, and are not intended to limit the protection scope of the invention which is defined by the appended claims.

## Claims

1. A monitoring system for circular current of a high-voltage cable metal sheath, comprising a mobile vehicle (1), wherein a lifting assembly (2) is mounted on one side of the mobile vehicle (1), a pushing assembly (3) is horizontally mounted at an end, stretching out of a top of the mobile vehicle (1), of the lifting assembly (2), a detection assembly (4) is connected to an end, away from the lifting assembly (2), of the pushing assembly (3) and comprises a detection mechanism (5) fixedly connected with an output end of the pushing assembly (3), and a protection mechanism (6) is connected to one side of the detection mechanism (5);
the detection mechanism (5) comprises a rotary shaft (508) which is movably connected with the output end of the pushing assembly (3), a fixed connecting plate (507) which is fixedly connected with the output end of the pushing assembly (3) is movably connected to an outer circle of the rotary shaft (508), a movable connecting plate (509) which is fixedly connected with the rotary shaft (508) is mounted on a side, away from the pushing assembly (3), of the fixed connecting plate (507), housings (501) which are each of an arc structure and each have two ends formed with openings are fixedly connected to identical sides of the movable connecting plate (509) and the fixed connecting plate (507), the two housings (501) are opposite to each other, magnetic cores (502) which are coaxial with the housings (501) and are each of an arc structure are mounted in the two housings (501), coils (503) which are each of a circular structure are wound on outer circles of the magnetic cores (502), outer circles of the coils (503) are clad with clad layers (504) which are fixedly connected with inner walls of the housings (501), contact blocks (505) are fixedly connected to inner walls of the openings in the two ends of each of the two housings (501), and a wiring tube (506) is fixedly connected to a top of the housing (501) located on the fixed connecting plate (507);
the protection mechanism (6) comprises shells (601) which are fixedly connected with outer walls of the housings (501), each have two ends formed with openings, and are each of a circular structure, the two shells (601) are coaxial with the adjacent housings (501), protection units (9) are mounted at the openings of the two shells (601), a connecting unit (7) which is of a circular structure is fixedly connected to tops of sides, close to each other, of the two protection units (9) in each said shell (601), and pushing units (8) for opening and closing the protection units (9) are mounted at the openings in sides, close to the rotary shaft (508), of the shells (601).

2. The monitoring system for circular current of a high-voltage cable metal sheath according to Claim 1, wherein each said protection unit (9) comprises protection plates (901) located at the openings in the two ends of the corresponding shell (601), first guide tubes (902) are fixedly connected to tops of sides, close to each other, of the two protection plates (901) and are located over ends, away from the corresponding housing (501), of the protection plates (901), movable rods (903) are movably connected into the first guide tubes (902), springs which are fixedly connected with tops of the protection plates (901) are fixedly connected to ends, stretching into the first guide tubes (902), of the movable rods (903), screw rods (904) which are disposed in a lengthwise direction of the protection plates (901) are connected to ends, stretching out of tops of the first guide tubes (902), of the movable rods (903) in a threaded manner and are movably connected with an inner wall of the corresponding shell (601), gears (905) are fixedly connected to outer circles of the screw rods (904), abutting plates (906) which are disposed in the lengthwise direction of the protection plates (901) are fixedly connected to tops of sides, away from each other, of the two protection plates (901), and tops of sides, close to the corresponding housing (501), of the abutting plates (906) abut against pushing blocks (907) which are fixedly connected with the inner wall of the corresponding shell (601).

3. The monitoring system for circular current of a high-voltage cable metal sheath according to Claim 1, wherein each said pushing unit (8) comprises a second guide tube (801) which is fixedly connected with an inner wall of an outer circle of the corresponding shell (601) and is of an arc structure, a pushing plate (802) which is of an arc structure is slidably connected into the second guide tube (801), an end, stretching out of the second guide tube (801), of the pushing plate (802) is fixedly connected with the inner wall of the outer circle of the adjacent shell (601), and a rack (803) which is disposed in a lengthwise direction of the pushing plate (802) and is of an arc structure is fixedly connected to a concave face of the pushing plate (802), and is engaged with a gear (905).

4. The monitoring system for circular current of a high-voltage cable metal sheath according to Claim 1, wherein each said connecting unit (7) comprises a connecting rod (702) which is slidably connected with an inner wall of an inner circle of the corresponding shell (601) and is of an arc structure, and the connecting rod (702) slides in an axis direction of the corresponding shell (601) and has two ends slidably sleeved with third guide tubes (701) which are fixedly connected with tops of the adjacent protection plates (901).

5. The monitoring system for circular current of a high-voltage cable metal sheath according to Claim 1, wherein a storage cavity which is of a hollow structure is formed in the mobile vehicle (1), and wheels for moving the mobile vehicle are mounted at a bottom of the mobile vehicle (1).

6. The monitoring system for circular current of a high-voltage cable metal sheath according to Claim 1, wherein the lifting assembly (2) comprises a first lifting tube (102) movably connected with the mobile vehicle (1) and is able to slide vertically with respect to the mobile vehicle (1), a second lifting tube (103) which is able to move in a lengthwise direction of the first lifting tube (102) is slidably connected with an end, stretching out of a top of the mobile vehicle (1), of the first lifting tube (102), an end, stretching out of the first lifting tube (102), of the second lifting tube (103) is fixedly connected with a bottom of the pushing assembly (3), a first rotary tube (104) is connected to an inner circle of the second lifting tube (103) in a threaded manner, an adapter rod (105) which slides in a lengthwise direction of the first rotary tube (104) is slidably connected to an inner circle of a bottom of the first rotary tube (104), a driving rod (106) is fixedly connected to a bottom of the adapter rod (105), a second rotary tube (101) which is movably connected with an inner circle of the first lifting tube (102) in a threaded manner is slidably connected to an outer circle of the driving rod (106), and a driving mechanism (107) is fixedly connected to an outer circle of an end, stretching out of the first lifting tube (102), of the second rotary tube (101).

7. The monitoring system for circular current of a high-voltage cable metal sheath according to Claim 6, wherein the driving mechanism (107) comprises a gear ring which is fixedly connected with an outer circle of a bottom of the second rotary tube (101), one side of the gear ring is engaged with a second gear, a first rotary shaft is fixedly connected to an inner circle of the second gear, a first motor which is fixedly connected with an inner wall of a bottom of a storage cavity of the mobile vehicle (1) is mounted at a bottom of the first rotary shaft, a retainer plate which is movably connected with the second rotary tube (101) is mounted on one side of the gear ring and is fixedly connected with an inner wall of the storage cavity, and a second motor which is fixedly connected with the inner wall of the bottom of the storage cavity is fixedly connected to an end, stretching out of the bottom of the second rotary tube (101), of the driving rod (106).

## Patentansprüche

1. Überwachungssystem für Stromfluss in Metallummantelung eines Hochspannungskabels, umfassend ein mobiles Fahrzeug (1), wobei eine Hubanordnung (2) auf einer Seite des mobilen Fahrzeugs (1) angebracht ist; eine Schubanordnung (3) horizontal an dem Ende angebracht ist, das sich aus der Oberseite der Hubanordnung (2) des mobilen Fahrzeugs (1) erstreckt; eine Erfassungsanordnung (4) mit dem Ende der Schubanordnung (3) verbunden ist, das von der Hubanordnung (2) beabstandet ist, und einen Erfassungsmechanismus (5) umfasst, der fest mit dem Ausgangsende der Schubanordnung (2) verbunden ist (3); und ein Schutzmechanismus (6) mit einer Seite des Erfassungsmechanismus (5) verbunden ist; wobei
der Erfassungsmechanismus (5) Folgendes umfasst: eine rotierende Welle (508), die beweglich mit dem Ausgangsende der Schubanordnung (3) verbunden ist; eine feste Verbindungsplatte (507), die fest mit dem Ausgangsende der Schubanordnung (3) verbunden ist (3) und beweglich mit dem äußeren Kreis der rotierenden Welle (508) verbunden ist; eine bewegliche Verbindungsplatte (509), die fest mit der rotierenden Welle (508) verbunden ist und auf der Seite der festen Verbindungsplatte (507) angebracht ist, die von der Schubvorrichtung (3) entfernt ist; Gehäuse (501), die jeweils eine Bogenstruktur haben und jeweils zwei mit Öffnungen ausgebildete Enden aufweisen, die fest mit den identischen Seiten der beweglichen Verbindungsplatte (509) und der festen Verbindungsplatte (507) verbunden sind, wobei die zwei Gehäuse (501) einander gegenüberliegen; Magnetkerne (502), die koaxial zu den Gehäusen (501) sind, eine Bogenstruktur haben und in den beiden Gehäusen (501) montiert sind; Spulen (503), die kreisförmig auf die äußeren Kreise der Magnetkerne (502) gewickelt sind, wobei die äußeren Kreise der Spulen (503) mit plattierten Schichten (504) überzogen sind, die fest mit Innenwänden der Gehäuse (501) verbunden sind; Kontaktblöcke (505), die fest mit den Innenwänden der Öffnungen an den beiden Enden jedes der beiden Gehäuse (501) verbunden sind; und ein Verdrahtungsrohr (506), das fest mit der Oberseite des Gehäuses (501) verbunden ist, das sich auf der festen Verbindungsplatte (507) befindet;
der Schutzmechanismus (6) Schalen (601) umfasst, die fest mit Außenwänden der Gehäuse (501) verbunden sind, jeweils zwei mit Öffnungen ausgebildete Enden haben und jeweils eine kreisförmige Struktur aufweisen, wobei die beiden Schalen (601) koaxial zu den benachbarten Gehäusen (501) sind, die Schutzeinheiten (9) an den Öffnungen der beiden Schalen (601) montiert sind, eine Verbindungseinheit (7), die eine kreisförmige Struktur hat, fest mit den Oberseiten der zwei nahe beieinander liegenden Schutzeinheiten (9) in jeder der Schalen (601) verbunden ist, und Schubeinheiten (8) zum Öffnen und Schließen der Schutzeinheiten (9) an den Öffnungen der Seiten der Schalen (601) nahe der rotierenden Welle (508) angebracht sind.

2. Überwachungssystem für Stromfluss in Metallummantelung eines Hochspannungskabels nach Anspruch 1, wobei jede Schutzeinheit (9) Schutzplatten (901) umfasst, die in den Öffnungen an den zwei Enden der entsprechenden Schale (601) angeordnet sind, erste Führungsrohre (902) fest nahe beieinander mit den Oberseiten der zwei Schutzplatten (901) verbunden sind und über die Enden der Schutzplatten (901) entfernt vom entsprechenden Gehäuse (501) angeordnet sind, bewegliche Stangen (903) beweglich mit den ersten Führungsrohren (902) verbunden sind, Federn, die fest mit den Oberseiten der Schutzplatten (901) verbunden sind, fest mit den Enden der beweglichen Stangen (903) verbunden sind, die sich in die ersten Führungsrohre (902) erstrecken, Gewindestangen (904), die in Längsrichtung der Schutzplatten (901) angeordnet sind, mit den Enden, die sich aus den Oberseiten der ersten Führungsrohre (902) der beweglichen Stangen (903) heraus erstrecken, durch ein Gewinde verbunden sind und beweglich mit der Innenwand der entsprechenden Schale (601) verbunden sind, Zahnräder (905) fest mit den äußeren Kreisen der Gewindestangen (904) verbunden sind, Stoßplatten (906), die in Längsrichtung der Schutzplatten (901) angeordnet sind, mit den Oberseiten der beiden Schutzplatten (901) im Abstand voneinander fest verbunden sind, und die Oberseiten der Stoßplatten (906) nahe dem entsprechenden Gehäuse (501) an Schubblöcken (907) anliegen, die fest mit der Innenwand der entsprechenden Schale (601) verbunden sind.

3. Überwachungssystem für Stromfluss in Metallummantelung eines Hochspannungskabels nach Anspruch 1, wobei jede Schubeinheit (8) ein zweites Führungsrohr (801), das fest mit der Innenwand des äußeren Kreises des entsprechenden Schale (601) verbunden ist und von bogenförmiger Struktur ist, umfasst, eine Schubplatte (802), die eine bogenförmige Struktur aufweist, verschiebbar mit dem zweiten Führungsrohr (801) verbunden ist, ein Ende, das sich aus dem zweiten Führungsrohr (801) der Schubplatte (802) erstreckt, fest mit der Innenwand des äußeren Kreises der benachbarten Schale (601) verbunden ist, und eine Zahnstange (803), die in Längsrichtung der Schubplatte (802) angeordnet ist, eine Bogenstruktur hat, fest mit der konkaven Fläche der Schubplatte (802) verbunden ist und mit dem Zahnrad (905) in Eingriff steht.

4. Überwachungssystem für Stromfluss in Metallummantelung eines Hochspannungskabels nach Anspruch 1, wobei jede Verbindungseinheit (7) eine Verbindungsstange (702) umfasst, die verschiebbar mit der Innenwand des inneren Kreises der entsprechenden Schale (601) verbunden ist und eine Bogenstruktur hat, wobei die Verbindungsstange (702) in Achsenrichtung der entsprechenden Schale (601) gleitet und zwei Enden hat, die verschiebbar in die dritten Führungsrohre (701) eingeschoben sind, die fest mit den Oberseiten der benachbarten Schutzplatten (901) verbunden sind.

5. Überwachungssystem für Stromfluss in Metallummantelung eines Hochspannungskabels nach Anspruch 1, wobei ein Stauraum, der eine hohle Struktur hat, im mobilen Fahrzeug (1) ausgebildet ist, und die Räder zum Bewegen des mobilen Fahrzeugs an der Unterseite des mobilen Fahrzeugs (1) montiert sind.

6. Überwachungssystem für Stromfluss in Metallummantelung eines Hochspannungskabels nach Anspruch 1, wobei die Hubanordnung (2) Folgendes umfasst: ein erstes Hubrohr (102), das beweglich mit dem mobilen Fahrzeug (1) verbunden ist und vertikal im Bezug zum mobilen Fahrzeug (1) rutschen kann, ein zweites Hubrohr (103), das sich in Längsrichtung des ersten Hubrohrs (102) bewegen kann und verschiebbar mit dem Ende des ersten Hubrohrs verbunden ist, das sich aus der Oberseite des mobilen Fahrzeugs (1) erstreckt (102), ein Ende, das sich aus dem ersten Hubrohr (102) des zweiten Hubrohrs (103) erstreckt und fest mit der Basis der Schubanordnung (3) verbunden ist, ein erstes rotierendes Rohr (104), das mit dem inneren Kreis des zweiten Hubrohrs (103) durch ein Gewinde verbunden ist, eine Adapterstange (105), die in Längsrichtung des ersten rotierenden Rohrs (104) rutscht und verschiebbar mit dem inneren Kreis der Basis des ersten rotierenden Rohrs (104) verbunden ist, eine Antriebsstange (106), die fest mit der Basis der Adapterstange (105) verbunden ist, ein zweites rotierendes Rohr (101), das mit dem inneren Kreis des ersten Hubrohrs (102) durch ein Gewinde beweglich verbunden ist und mit dem äußeren Kreis der Antriebsstange (106) verschiebbar verbunden ist, und einen Antriebsmechanismus (107), der fest mit dem äußeren Kreis des Endes verbunden ist, das sich aus dem ersten Hubrohr (102) des zweiten rotierenden Rohrs (101) erstreckt.

7. Überwachungssystem für Stromfluss in Metallummantelung eines Hochspannungskabels nach Anspruch 6, wobei der Antriebsmechanismus (107) Folgendes umfasst: einen Zahnkranz, der fest mit dem äußeren Kreis der Basis des zweiten rotierenden Rohrs (101) verbunden ist, wobei eine Seite des Zahnkranzes mit dem zweiten Zahnrad in Eingriff steht, und die erste rotierende Welle fest mit dem inneren Kreis des zweiten Zahnrads verbunden ist; den ersten Motor, der fest mit der Innenwand der Basis des Stauraums des mobilen Fahrzeugs (1) verbunden ist und an der Basis der ersten rotierende Welle montiert ist; eine mit dem zweiten rotierenden Rohr (101) beweglich verbundene Halteplatte, die auf einer Seite des Zahnkranzes montiert und mit der Innenwand des Stauraumes fest verbunden ist, und einen zweiten Motor, der fest mit der Innenwand der Basis des Stauraumes verbunden ist und fest mit dem Ende verbunden ist, das sich aus der Basis des zweiten rotierenden Rohrs (101) der Antriebsstange (106) erstreckt.

## Revendications

1. Système de surveillance du courant circulaire d'une gaine métallique de câble à haute tension, comprenant un véhicule mobile (1), dans lequel un ensemble de levage (2) est monté sur un côté du véhicule mobile (1), un ensemble de poussée (3) est monté horizontalement à une extrémité, s'étendant au-delà d'un sommet du véhicule mobile (1), de l'ensemble de levage (2), un ensemble de détection (4) est relié à une extrémité, éloignée de l'ensemble de levage (2), de l'ensemble de poussée (3) et comprend un mécanisme de détection (5) relié de manière fixe à une extrémité de sortie de l'ensemble de poussée (3), et un mécanisme de protection (6) est relié à un côté du mécanisme de détection (5) ;
le mécanisme de détection (5) comprend un arbre rotatif (508) qui est relié de manière mobile à l'extrémité de sortie de l'ensemble de poussée (3), une plaque de liaison fixe (507) qui est reliée de manière fixe à l'extrémité de sortie de l'ensemble de poussée (3) est relié de manière mobile à un cercle extérieur de l'arbre rotatif (508), une plaque de liaison mobile (509) qui est relié de manière fixe à l'arbre rotatif (508) est montée sur un côté, à l'opposé de l'ensemble de poussée (3), de la plaque de liaison fixe (507), des boîtiers (501) qui sont chacun une structure en arc et chacun ayant deux extrémités formées avec des ouvertures reliées de manière fixe à des côtés identiques de la plaque de liaison mobile (509) et de la plaque de liaison fixe (507), les deux boîtiers (501) sont opposés l'un à l'autre, des noyaux magnétiques (502) qui sont coaxiaux avec les boîtiers (501) et sont chacun d'une structure en arc montés dans les deux boîtiers (501), des bobines (503) qui sont chacune d'une structure circulaire sont enroulés sur les cercles extérieurs des noyaux magnétiques (502), les cercles extérieurs des bobines (503) sont revêtus de couches de revêtement (504) qui sont reliées de manière fixe aux parois intérieures des boîtiers (501), des blocs de contact (505) sont connectés de manière fixe aux parois intérieures des ouvertures dans les deux extrémités de chacun des deux boîtiers (501), et un tube de câblage (506) est connecté de manière fixe à un sommet du boîtier (501) situé sur la plaque de connexion fixe (507) ;
le mécanisme de protection (6) comprend des coques (601) qui sont reliés de manière fixe aux parois extérieures des boîtiers (501), ont chacune deux extrémités formées avec des ouvertures, et sont chacune d'une structure circulaire, les deux coques (601) sont coaxiales avec les logements adjacents (501), des unités de protection (9) sont montées au niveau des ouvertures des deux coques (601), une unité de liaison (7) qui est de structure circulaire est reliée fixement à des sommets de côtés, proches l'un de l'autre, des deux unités de protection (9) dans chacune desdites coques (601), et des unités de poussée (8) pour ouvrir et fermer les unités de protection (9) sont montées au niveau des ouvertures sur les côtés, à proximité de l'arbre rotatif (508), des coques (601).

2. Système de surveillance de courant circulaire d'une gaine métallique de câble à haute tension selon la revendication 1, dans laquelle chacune desdites unités de protection (9) comprend des plaques de protection (901) situées au niveau des ouvertures dans les deux extrémités de la coque correspondante (601), les premiers tubes de guidage (902) sont reliés de manière fixe aux sommets des côtés, à proximité l'un de l'autre, des deux plaques de protection (901) et sont situés sur des extrémités, éloignés du boîtier correspondant (501), des plaques de protection (901), des tiges mobiles (903) sont reliées de manière mobile dans les premiers tubes de guidage (902), des ressorts reliés de manière fixe aux sommets des plaques de protection (901) reliés de manière fixe aux extrémités, s'étendant dans les premiers tubes de guidage (902), des tiges mobiles (903), des tiges filetées (904) qui sont disposées dans le sens de la longueur des plaques de protection (901) sont reliées aux extrémités, s'étendant au-delà des sommets des premiers tubes de guidage (902), des tiges mobiles (903) de manière filetée et sont reliés de manière mobile à une paroi intérieure de la coque correspondante (601), des engrenages (905) sont reliés de manière fixe aux cercles extérieurs des tiges filetées (904), des plaques de butée (906) qui sont disposées dans le sens de la longueur des plaques de protection (901) sont reliées de manière fixe aux sommets des côtés, à distance l'une de l'autre, des deux plaques de protection (901), et des sommets de côtés, proches du boîtier (501) correspondant, des plaques d'appui (906) butent contre des blocs de poussée (907) qui sont reliés de manière fixe à la paroi intérieure de la coque correspondante (601).

3. Système de surveillance du courant circulaire d'une gaine métallique de câble à haute tension selon la revendication 1, dans laquelle chacune desdites unités de poussée (8) comprend un deuxième tube de guidage (801) qui est relié de manière fixe à une paroi intérieure d'un cercle extérieur de la coque correspondante (601) et est d'une structure en arc, une plaque de poussée (802) qui est d'une structure en arc est connectée de manière coulissante dans le second tube de guidage (801), une extrémité, s'étendant hors du second tube de guidage (801), de la plaque de poussée (802) est connectée de manière fixe avec la paroi intérieure du cercle extérieur de la coque adjacente (601), et un support (803) qui est disposé dans une direction longitudinale de la plaque de poussée (802) et est d'une structure en arc est relié de manière fixe à une face concave de la plaque de poussée (802), et est en prise avec un engrenage (905).

4. Système de surveillance du courant circulaire d'une gaine métallique de câble à haute tension selon la revendication 1, dans laquelle chacune desdites unités de connexion (7) comprend une tige de connexion (702) qui est connectée de manière coulissante à une paroi interne d'un cercle interne de la coque correspondante (601) et est d'une structure en arc, et est d'une structure en arc, et la tige de connexion (702) coulisse dans une direction axiale de la coque correspondante (601) et a deux extrémités gainées de manière coulissante avec des troisièmes tubes de guidage (701) qui sont reliés de manière fixe aux sommets des plaques de protection adjacentes (901).

5. Système de surveillance du courant circulaire d'une gaine métallique de câble à haute tension selon la revendication 1, dans laquelle une cavité de stockage qui est d'une structure creuse est formée dans le véhicule mobile (1), et des roues pour déplacer le véhicule mobile sont montées à la base du véhicule mobile (1).

6. Système de surveillance du courant circulaire d'une gaine métallique de câble haute tension selon la revendication 1, dans laquelle l'ensemble de levage (2) comprend un premier tube de levage (102) relié de manière mobile au véhicule mobile (1) et capable de glisser verticalement par rapport au véhicule mobile (1), un second tube de levage (103) capable de se déplacer dans le sens de la longueur du premier tube de levage (102) est relié de manière coulissante à une extrémité du premier tube de levage (102) s'étendant sur le dessus du véhicule mobile (1), une extrémité du second tube de levage (103) s'étendant sur le premier tube de levage (102) est reliée de manière fixe à la base de l'ensemble de poussée (3), un premier tube rotatif (104) est relié à un cercle intérieur du second tube de levage (103) de manière filetée, une tige d'adaptation (105) qui coulisse dans le sens de la longueur du premier tube rotatif (104) est reliée de manière coulissante à un cercle intérieur de la base du premier tube rotatif (104), une tige d'entraînement (106) est reliée de manière fixe à la base de la tige d'adaptation (105), un second tube rotatif (101) qui est relié de manière mobile à un cercle intérieur du premier tube de levage (102) de manière filetée est relié de manière coulissante à un cercle extérieur de la tige d'entraînement (106), et un mécanisme d'entraînement (107) est relié de manière fixe à un cercle extérieur d'une extrémité, s'étendant hors du premier tube de levage (102), du second tube rotatif (101).

7. Système de surveillance du courant circulaire d'une gaine métallique de câble à haute tension selon la revendication 6, dans laquelle le mécanisme d'entraînement (107) comprend une couronne dentée qui est reliée de manière fixe à un cercle extérieur de la base du second tube rotatif (101), un côté de la couronne dentée est en prise avec un second engrenage, un premier arbre rotatif est relié fixement à un cercle intérieur du second engrenage, un premier moteur qui est relié de manière fixe à une paroi intérieure de la base d'une cavité de stockage du véhicule mobile (1) est monté sur la base du premier arbre rotatif, une plaque de retenue qui est reliée de manière mobile au second tube rotatif (101) est montée sur un côté de la couronne dentée et est reliée de manière fixe à une paroi intérieure de la cavité de stockage, et un second moteur qui est relié de manière fixe à la paroi intérieure du fond de la cavité de stockage est relié de manière fixe à une extrémité de la tige d'entraînement (106) qui s'étend à l'extérieur de la base du second tube rotatif (101).
